# EUROPÄISCHE PATENTSCHRIFT

(11) **EP 2 668 483 B1**
(45) Veröffentlichungstag und Bekanntmachung des Hinweises auf die Patenterteilung: **18.11.2015**
(21) Anmeldenummer: 12708743.5
(22) Anmeldetag: 27.01.2012
(51) Int. Cl.: G01L 27/00, B81C 99/00

(54) **MIKROELEKTROMECHANISCHES BAUELEMENT UND VERFAHREN ZUM TESTEN EINES MIKROELEKTROMECHANISCHEN BAUELEMENTS**
MICROELECTROMECHANICAL COMPONENT AND METHOD FOR TESTING A MICROELECTROMECHANICAL COMPONENT
COMPOSANT MICROELECTROMECANIQUE ET PROCEDE POUR TESTER UN COMPOSANT MICROELECTROMECANIQUE

(30) Priorität: 28.01.2011 EP 11152566
(43) Veröffentlichungstag der Anmeldung: 04.12.2013
(73) Patentinhaber: ELMOS Semiconductor AG, 44227 Dortmund (DE); Silicon Microstructures, Inc., Milpitas, CA 95035 (US)
(72) Erfinder: BURCHARD, Bernd, 44227 Dortmund (DE); DOELLE, Michael, Milpitas, California 95035 (US)
(74) Vertreter: Von Kreisler Selting Werner - Partnerschaft von Patentanwälten und Rechtsanwälten mbB
(86) Internationale Anmeldenummer: PCT/EP2012/051336
(87) Internationale Veröffentlichungsnummer: WO 2012/101257

(56) Entgegenhaltungen:
- EP-A2- 0 118 605
- WO-A2-2008/061832
- US-A- 5 355 712
- PUERS R ET AL: "On the mechanisms in thermally actuated composite diaphragms", SENSORS AND ACTUATORS A: PHYSICAL, Bd. 67, Nr. 1 -3, 21. September 1997 (1997-09-21), Seiten 13-17, XP002638954, ELSEVIER SCIENCE S.A. DOI: 10.1016/S0924-4247(97)01721-4 in der Anmeldung erwähnt

## Beschreibung

Die Erfindung betrifft im Allgemeinen eine mikroelektromechanische Vorrichtung mit speziellen Funktionselementen, die den Selbsttest dieser Vorrichtung ermöglichen, und das zugehörige Verfahren zur Durchführung eines Selbsttests unter Benutzung dieser speziellen Funktionselemente.

Die Fertigungsprüfung mikromechanischer Vorrichtungen in der industriellen Serienproduktion erfolgt heute typischerweise als Funktionsprüfung. Bereits von der Prüfung integrierter Digitalschaltungen ist es bekannt, dass die Fehlerabdeckung von Funktionsprüfungen gemessen an einfachen stuck-at-0 stuck-at-1 Fehlermodellen selten mehr als 70% erreicht. Daher wurden spezielle Testmethoden entwickelt, die die Testabdeckung wesentlich erhöhen. Beispielhaft kann hier die Scan-Pfad-Methodik genannt werden. Charakteristikum der heutigen Tests, die zudem wesentlich schneller ablaufen, ist, dass nicht die Funktion des Systems, sondern die korrekte Realisierung geprüft wird. Die Funktionsprüfungen beschränken sich dann auf wenige kritische Fälle, die repräsentativ für die Gesamtfunktion stehen.

Diese Erfahrungen aus der Fertigung integrierter elektronischer Schaltkreise sind auf mikroelektromechanische Systeme zu übertragen.

Als Beispiel für die Prüfproblematik mikroelektromechanischer Systeme soll diese anhand eines Differenzdrucksensors für niedrige Drücke erläutert werden.

Ein solches beispielhaftes System verfügt über Nichtlinearitäten. Zum einen verfügt der Sensor über einen Offset, der messtechnisch leicht zu erfassen ist.

Zum anderen ist der Sensor nicht linear. Dies erfordert mindestens drei Druckmesspunkte. Unter anderem wird dabei auch die Sensitivität ermittelt.

Außerdem sind sowohl Offset als auch Linearität und Sensitivität von der Temperatur nicht linear abhängig. Somit ergeben sich mindestens drei Temperaturpunkte für die Messung und Kalibration.

Die Einstellung der mindestens neun Druck-/Temperatur-Punkte erfordert erhebliche Zeit, insbesondere wenn es sich wie bei dem hier diskutierten Fall um einen Niedrigdruck-Differenzdrucksensor handelt. Hierbei werden Mess- und Kalibrationszeiten im mehrstelligen Minutenbereich erreicht.

Die US-A-2009/0174418 offenbart bereits eine Methodik, die dem obigen Zweck dienen kann.

Allerdings dient die bekannte Methodik lediglich dem Zweck, eine Membrandicke zu ermitteln. Insbesondere ermöglicht sie nicht die saubere Trennung von Temperatur und mechanischem Stress. Dies ist aber notwendig, um die oben beschriebenen Kalibrierungen sauber vornehmen zu können.

Des Weiteren werden nach der bekannten Methodik piezoresistive Elemente für die Detektion des mechanischen Stresses verwendet. Diese weisen einige Nachteile gegenüber anderen stresssensitiven Elementen auf.

Insbesondere ist entweder eine große Bauform, wie auch in der US-A-2009/0174418 in der dortigen Fig. 1 richtig dargestellt, notwendig, die die Messung des lokalen mechanischen Stresses verhindert, oder aber es wird eine kleine piezo-resistive Wheatstone-Brücke verwendet, die dann jedoch eine höhere Bestromung erfordert und somit eine zusätzliche thermische Last für die zu vermessende Membran einbringt.

Ein weiteres Problem ergibt sich bei der Verwendung der oben angesprochenen Differenzdrucksensoren in Zielsystemen. In der Regel wird ein solcher Sensor in ein Gehäuse eingebaut. Durch die Montage, typischerweise eine Verlötung oder Verklebung mit einer gedruckten Schaltung, kommt es infolge des Montageprozesses und des späteren Gebrauches zu Verwindungen und Verzerrungen des Sensors, was sich in fehlerhaften Signalen äußert. Daher ist es sinnvoll, nach Verbau eines Sensors diesen jederzeit vermessen zu können, ohne dass ein Druck-Equipment benutzt werden muss.

Aus WO-A-2008/061832 ist ein mikroelektromechanisches Bauteil mit einer eine Kavität überspannenden Membran bekannt, auf der zwei Piezowiderstände als Sensoren zur Erkennung einer Verformung und ein Heizelement als Aktuator zur Induzierung einer Membranverformung angeordnet sind. Während die beiden Sensoren im Randbereich der Membran und damit in Bereichen maximierter Materialspannungen der Membran bei deren Verformung angeordnet sind, befindet sich der Aktuator in der Mitte der Membran, wo seine thermische Kopplung an die Sensorelemente im Mittel maximal ist, was nachteilig sein kann.

Ein ähnliches Bauteil wie das zuvor beschriebene ist auch aus DE-A-10 2010 001 153 bekannt. Der Sensor ist als sich über die Membran erstreckende kapazitive Messbrücke ausgebildet. Der Aktuator ist wiederum ein Heizer, der mittig der Membran angeordnet ist.

In US-A-5 355 712 ist ein Druck- bzw. Kraftsensor gemäß dem Oberbegriff des Anspruchs 1 beschrieben, der als Membran einen Biegebalken aufweist. An seinem Befestigungsende weist der Biegebalken einen Aktuator und einen Sensorelement auf, die eng benachbart angeordnet sind.

Weitere mikromechanische Bauelemente sind in EP-A-0 118 605 und in dem Artikel von Puers, R, et al: "On the mechanisms in thermally actuated composite diaphragms", in Sensors and Actuators A 67 (1998), S. 13-17, beschrieben.

Die Erfindung stellt sich daher die Aufgabe, einen (insbesondere Hochgeschwindigkeits-)Test mikroelektromechanischer Systeme mittels eingebauter

Testhilfen zu ermöglichen. Diese Testhilfen sollen mechanische von sonstigen Parametern wie beispielsweise Temperatur trennen können. Sie sollten daher mindestens einen möglichst kompakten kleinen Aktuator und mindestens einen ebenfalls möglichst kleinen Sensor aufweisen, der selbst nicht als parasitärer Aktuator z.B. durch thermische Last und folgende thermomechanische Ausdehnung wirkt. Die Testhilfen sollen vorzugsweise auch nach dem Verbau und der Inbetriebnahme weiterhin nutzbar sein.

Zur Lösung dieser Aufgabe wird mit der Erfindung ein mikroelektromechanisches Bauelement mit den Merkmalen des Anspruchs 1 vorgeschlagen.

Die zuvor genannte Aufgabe wird ferner durch ein Verfahren zum Testen der Funktionalität eines mikroelektromechanischen Bauelements gemäß Anspruch 7 gelöst.

Einzelne Ausgestaltungen der Erfindung sind Gegenstand der Unteransprüche.

Nach der Erfindung ist also vorgesehen, ein mikroelektromechanisches Bauelement mit einer beispielsweise infolge von außen wirkenden Kräften oder Drücken reversibel verformbaren Membran mit einer Teststruktur zu versehen, die einen Selbsttest des Bauelements sowohl in qualitativer als auch lediglich in quantitativer Weise ermöglicht. Eine quantitative Untersuchung ist mit Hilfe des erfindungsgemäßen Bauelements insoweit möglich, als dass nach dessen Fertigung eine automatische Überprüfung daraufhin möglich ist, ob die Membran überhaupt vorhanden ist. Eine qualitative Untersuchung kann mit dem erfindungsgemäßen Bauelement und dem erfindungsgemäßen Verfahren insoweit durchgeführt werden, als dass der Grad einer zu Testzwecken erfolgenden Verformung der Membran (nämlich durch den Aktuator) anschließend messtechnisch mit vorgebbaren Toleranzen erfasst werden kann. Der Vergleich zeigt dann, ob das mikroelektromechanische Bauelement innerhalb eines Fertigungstoleranzbereichs liegt oder nicht. Auf diese Weise können Gutteile von Schlechtteilen unterschieden werden.

Erfindungsgemäß besteht die Besonderheit des mikroelektromechanischen Bauelements darin, dass der Testaktuator und der Sensor jeweils in Bereichen maximaler Materialspannungen der Membran bei deren Verformung angeordnet sind, wobei diejenigen dieser Bereiche ausgewählt sind, die den maximalen Abstand voneinander aufweisen. Bei einer Membran, die als zwei- bzw. mehrseitig eingespannter Balken betrachtet werden kann, befinden sich der Testaktuator und der Sensor also beispielsweise an (diametral) gegenüberliegenden Stellen und im Randbereich der Membran. Wenn mehrere Sensoren Verwendung finden, so sollte erfindungsgemäß darauf geachtet werden, dass ihr jeweiliger Abstand zum Testaktuator maximal und damit die thermische Kopplung dynamisch betrachtet minimal ist.

Im Gegensatz zum Stand der Technik wird bei der Erfindung also darauf abgestellt, dass der Testaktuator (beispielsweise ein Heizer) und der Sensor bzw. jeder der Sensoren jeweils im Bereich des Entstehens maximaler Materialspannungen (bei einer Verformung der Membran) angeordnet sind, wobei zusätzlich der Testaktuator in einem maximal möglichen Abstand zum Sensor bzw. zu jedem Sensor platziert ist. Dies ermöglicht eine optimale Trennung der gegenseitigen Beeinflussung einer durch die Aktivität des Aktuators ausgelösten thermischen Welle (d.h. nicht kohärenten Phononen-Welle) und der mechanischen Welle (Körperschallwelle d.h. eine kohärente Phononen-Welle), die sich unterschiedlich schnell durch die Membran hindurch bewegen. Die vom Aktuator ausgelöste Welle ist zweckmäßigerweise wesentlich langsamer als die Körperschallwelle. Damit wird bei Ausbildung des Testaktuators als Thermoaktuator erreicht, dass die thermische Welle, die sich durch die Membran hindurch fortpflanzt, den Sensor bzw. die Sensoren später erreicht als die mechanische Welle, d.h. als die Körperschallwelle, die infolge der Verformung entsteht. Damit diese Trennung zuverlässig erfolgt, ist erfindungsgemäß die Maximierung des Abstandes zwischen dem Testaktuator und dem Sensor bzw. jedem der Sensoren vorgesehen.

Wie bereits oben erwähnt, kann die Membran physikalisch als Biegebalken aufgefasst werden, der zumindest an gegenüberliegenden Seiten eingespannt ist. Es ist aber auch denkbar, dass die Membran allseitig eingespannt ist. Bei einer in der Draufsicht rechteckigen bzw. viereckigen Form der Membran liegen der Testaktuator und der Sensor an gegenüberliegenden Rändern, und zwar vorzugsweise in den mittleren Bereichen der gegenüberliegenden Ränder, also in der Mitte zwischen den Ecken der gegenüberliegenden Ränder. Bei Ausbildung der Membran in runder Form liegen der Testaktuator und der Sensor vorzugsweise diametral gegenüber. Bei den zuvor genannten Stellen der zuvor genannten Membranformen bildet sich die maximale Materialspannung aus, wenn die Membran verformt wird. Insoweit bieten sich diese Positionen zur Anordnung von Testaktuator und Sensor erfindungsgemäß an.

Eine für die Testzwecke vorgesehene Auswerte- und Ansteuereinheit kann (integraler) Bestandteil des mikroelektromechanischen Bauelements sein (On-Chip-Ausbildung); es ist aber auch möglich, dass diese Auswerte- und Ansteuereinheit extern angeordnet ist. Der Ansteuerteil dieser Einheit dient insbesondere ausschließlich zu Testzwecken, während die Auswertestrukturen dieser Einheit auch beim Einsatz des Bauelements als Sensor zur Ermittlung mechanischer Kräfte oder Drücke Verwendung finden.

Mit dem erfindungsgemäßen Ansatz ist es möglich, das mikroelektromechanische Bauelement auch während seiner Einsatzdauer immer wieder Selbsttests zu unterziehen.

Im Zusammenhang mit der Erfindung ist mit dem Begriff "Membran" ein einseitig, zweiseitig, dreiseitig oder gar mehrseitig eingespanntes reversibel verformbares Element gemeint, in dem sich infolge der Verformung mechanische Spannungen aufbauen, die mit Hilfe des Sensors messtechnisch erfasst werden können.

Als Testaktuator kommen die verschiedensten Wandler in Frage, die aus einer beliebig gestalteten Ansteuerung eine Kraft zur (zumindest lokalen) Verformung der Membran erzeugen. Bei diesen Wandlern kann es sich um piezoresistive, elektrostatisch-mechanische, magnetostatische, elektrodynamische oder elektrothermische Wandler handeln, wobei insbesondere elektrothermische Wandler von Vorteil sind, da diese Wandler selbst in µm-Abmessungen noch genügend Kräfte entwickeln können, um Membranen von mikroelektromechanischen Bauelementen signifikant auslenken zu können.

Elektrothermische Wandler weisen zweckmäßigerweise ein als Widerstandsheizelement ausgebildetes Heizelement auf. Durch die thermisch eingebrachte lokale Erhitzung der Membran kommt es in dieser zu Spannungen, die sich in Form mechanischer Spannungen auswirken. Diese mechanischen Spannungen führen zu einer Verformung der Membran, die wiederum messtechnisch durch den Sensor erfassbar ist. Bessere Effekte erzielt man, wenn man im Bereich der lokalen Erhitzung der Membran einen Bimetall-Effekt erzeugen kann. Hierzu kann beispielsweise auf der Membran eine Materialschicht (beispielsweise Metallschicht) aufgebracht sein, so dass im Bereich des Heizelements zwei Materialien mit unterschiedlichen thermischen Ausdehnungskoeffizienten aneinander liegen. Dadurch, dass sich das eine Material bei Erwärmung in einem stärkeren Maße als das andere Material ausdehnt, kommt es zu einer Verformung der Membran. Die lokale Erhitzung der Membran sorgt hierbei für eine mechanische Verformung und damit für eine Körperschallwelle, die sich wesentlich schneller ausbreitet als die nachfolgende thermische Welle. Damit kommt es bei lokaler Erhitzung der Membran zunächst zu einer mechanischen Verformung, bevor die Membran und das auf ihr aufgebrachte Material letztendlich auf im Wesentlichen das gleiche Temperaturniveau erwärmt sind.

Weitere vorteilhafte Ausgestaltungen der Erfindung sind in den Unteransprüchen angegeben.

Der Sensor weist zweckmäßigerweise ein oder mehrere für mechanische Materialspannungen sensitive Widerstände oder Transistoren auf. Ein während des Selbsttests auf den Sensor einwirkender Wärmeeinfluss (bei Ausbildung des Testaktuators als Heizelement) kann bei Verwendung eines Transistors für den Sensor herausgerechnet werden, da die Threshhold-Spannung des Transistors temperaturabhängig ist. Als Transistor kommt beispielsweise ein piezoresistiver Transistor in Frage. Wenn das Temperaturverhalten des Sensors bekannt ist (was, wie zuvor erläutert, bei Transistoren der Fall ist), ist ein parasitärer thermischer Einfluss auf den Sensor aus dessen Messsignal "herausrechenbar".

Die Erfindung wird nachfolgend anhand mehrerer Ausführungsbeispiele und unter Bezugnahme auf die Zeichnung näher erläutert. Im Einzelnen zeigen dabei:
- Fig. 1: einen beispielhaften, nicht von der Erfindung erfassten mikromechanischen Differenzdrucksensor in Aufsicht,
- Fig. 2: einen beispielhaften mikromechanischen Absolutdrucksensor in Aufsicht,
- Fig. 3: die Antwort des beispielhaften Absolutdrucksensors auf eine beispielhafte Sinusanregung,
- Fig. 4: die Antwort des beispielhaften Absolutdrucksensors auf eine beispielhafte Rechteckanregung und
- Fig. 5: die Abhängigkeit des Sensorausgangssignals von der Aktuator-Stimulierung für ein Gut- und ein Schlechtteil.

Die Erfindung wird anhand eines Differenzdrucksensors für niedrige Drücke erläutert. Sie ist auf andere mikro(-elektro-)mechanische Systeme analog anwendbar. Sind die durch den Sensor im bestimmungsgemäßen Betrieb zu erfassenden Drücke zu gering, so werden die Zeiten bis zur Stabilisierung der Temperaturen und der Mechanik zu lang.

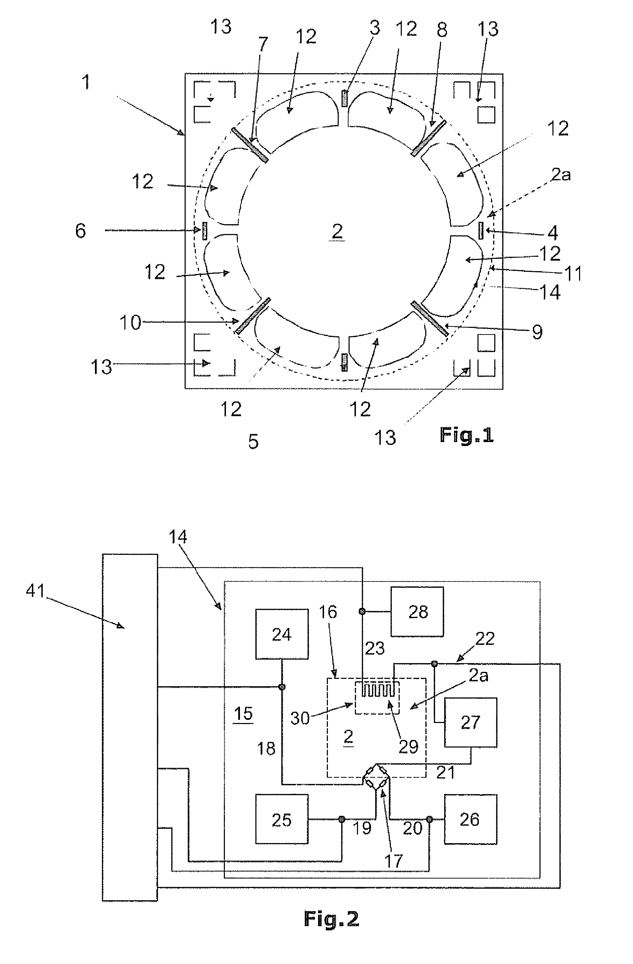

In Fig. 1 ist ein nicht unter die Erfindung fallender Sensor dargestellt. Er wird auf Basis beispielsweise eines Silizium-Wafers gefertigt und weist ein Halbleitersubstrat 1 mit einer Oberseite 1a auf.

Als erstes werden in dem beispielhaften Fall eines Drucksensors für niedrige Drücke die elektronischen Strukturen auf der Oberseite des Wafers gefertigt. In diesem Beispiel wird hierfür ein CMOS Prozess benutzt. Andere bekannte IC-Herstellungstechnologien sind ebenfalls anwendbar. Die Natur der elektronischen Strukturen wird später erläutert.

Um die für die Druckmessung notwendige Membran 2 zu fertigen, wird typischerweise von der Unterseite des Halbleitersubstrats 1 her in dieses eine Kavität 2a mittels DRIE- oder Plasma-Ätzverfahren in den Wafer geätzt. Diese Kavität 2a definiert zusammen mit der anderen Oberfläche des Wafers eine Membran.

Um dem Drucksensor die Fähigkeit eines Niedrigdrucksensors zu geben, wird die Membran durch einen ringförmigen oder quadratischen Graben 12 lokal ausgedünnt. Dieser Graben dient zur Modellierung des Stressfeldes und der Temperaturleitfähigkeit. Die Erfindung ist jedoch auf das Vorhandensein dieses Grabens nicht beschränkt.

Im Gegensatz zu bereits bekannten Lösungen, bei denen die Stressfeld-Modellierung zur gezielten Leitung des durch den mechanischen Druck auf die Membran erzeugten Nutz-Stresses dient, übernimmt sie hier auch die Verteilung des mechanischen Stresses, der durch zusätzliche Stresserzeugungs-Testaktuatoren eingebracht wird.

Ein wesentliches Problem ist die präzise Fertigung der Aktuatoren. Auf einer unstrukturierten Membran würde eine Fehlplatzierung der Sensoren, wie sie infolge Fertigungsschwankungen nicht auszuschließen ist, zu einer Änderung des auf die Sensoren einwirkenden Stressfeldes führen. Dies wird durch eine geeignete Ausformung der Stege vermieden. Diese werden so geformt, dass das Stressfeld sowohl bei Erzeugung durch mechanischen Druck auf die Membran als auch bei Erzeugung eines mechanischen Stressfeldes durch Testaktuatoren für die Sensoren nicht von den Lagetoleranzen für diese Sensoren abhängt. Die Ausformung der Stege ist kein für die Erfindung notwendiger Bestandteil.

Für die Testaktuatoren stellt sich die Forderung ein wenig anders dar: Eine Verschiebung der Testaktuatoren infolge von Fertigungsschwankungen sollte nicht zu einer Änderung des mechanischen Stressfeldes für die Sensoren führen.

Auch hier führt eine geeignete Formung der Stege zu einer begrenzten, aber ausreichenden Unabhängigkeit des auf die Sensoren einwirkenden mechanischen Stresses von der Lage der Testaktuatoren, wenn diese aktiviert werden.

Als Testaktuatoren kommen grundsätzlich elektrostatisch-mechanische Wandler, magnetostatische Wandler, elektrodynamische Wandler und elektrothermische Wandler in Frage.

Insbesondere elektrothermische Wandler können jedoch in µm-Maßstäben genügend Kräfte entwickeln, um direkt eine signifikante und für die Sensoren erfassbare Auslenkung der Membran zu erzeugen. Die anderen Wandler-Prinzipien sind nur geeignet, wenn Resonanzen angeregt werden können, die sich kumulieren.

Als elektrothermische Wandler eignen sich insbesondere elektrische Widerstände. Da die Lage gegenüber den Stressführungsstrukturen, die im beispielhaften Fall durch die Gräben 12 gebildet werden, von besonderer Bedeutung für die Präzision der Anregung ist, ist es sinnvoll, Gräben 12, Sensoren 3,4,5,6 und Aktuatoren 7,8,9,10 durch einen gemeinsamen Prozessschritt in ihrer Lage, horizontalen Form, Größe und Ausrichtung zueinander zu definieren. Das heißt, es ist besonders vorteilhaft, wenn es sich um einen selbstjustierenden Prozess handelt.

Typischerweise basieren selbstjustierende CMOS Fertigungsprozesse auf der Verwendung einer Gate-Poly-Silizium-Lage als selbstjustierende Maske für nachfolgende Implantationen im CMOS Prozess. Dieses Gate-Poly kann auch zur Dimensionierung der Widerstände und der Gräben genutzt werden.

Erst durch die Selbstjustierungskette Aktuator 7,8,9,10, Gräben 12, Sensor 3,4,5,6 ist sichergestellt, dass die Sensoren 3,4,5,6 bei korrekter Fertigung im Rahmen der dann noch verbleibenden Restfertigungstoleranzen immer ein ähnliches Stressfeld vermittelt bekommen.

Um den Einfluss der (vertikalen) Kavitätswand 11, die schlecht gegenüber den CMOS-Strukturen justiert werden kann, zu eliminieren, ist es wichtig, dass zwischen der zur Kavitätswand 11 nächstbenachbart angeordneten Außenkante des in der einen (Ober-)Seite 1a der Membran 2 ausgebildeten Grabensystems 14 und der Kavitätswand 11 ein Abstand eingehalten wird.

Um ein optimales Aktuatorsignal zu erhalten, ist es sinnvoll, die Tiefe der Gräben 12 so zu wählen, dass die Lage der neutralen Faser innerhalb der Stege mit Aktuatoren 7,8,9,10 bei Betätigung der Aktuatoren mit der Tiefe des Grabens 12 übereinstimmt. In diesem Fall hat der Aktuator 7,8,9,10 einen maximalen Hebel in Bezug auf die Auslenkung der Membran 2.

Um ein maximales Signal zu erhalten, ist es sinnvoll, die Aktuatoren 7,8,9,10 als selbstjustierende Widerstände auszuführen.

Die Messung der Membranreaktion erfolgt typischerweise, aber nicht notwendig, über eine Wheatstone-Brücke. Die Aktuatoren 7,8,9,10 führen zu einem thermischen Gradienten, der das z.B. in US-A-2009/0174418 beschriebene Verfahren für eine konventionelle Wheatstone Brücke mit piezoresistiven Widerständen jeweils in der Mitte der Nord- West-, Ost-, und Südkante der Membran unbrauchbar macht, da sich hier bereits Offsets ergeben, die einzig auf eine inhomogene Wärmeverteilung zurückzuführen sind. Ideal wäre also eine quasi punktförmige Wheatstone-Brücke. Hierfür eignet sich in besonderem Maße eine MOS-Transistor-Feldplatte mit vier Anschlüssen. Sofern diese mit einem Loch in der Mitte versehen ist, kann man diese Feldplatte auch als quadratische Verschaltung von vier Transistoren ansehen. Der große Vorteil einer solchen Platte ist ihre kompakte Bauform und die Möglichkeit der Kompensation parasitärer Elemente durch analoge Rechenschaltungen, die nicht Teil dieser Erfindung sind. Insgesamt sei auch hier angemerkt, dass die Art der elektrischen Verschaltung und die Anzahl der Selbsttest-Aktuatoren für die Erfindung in ihrer allgemeinsten Ausprägung nicht entscheidend sind.

Theoretisch würde auch die Verwendung eines einzelnen Basiselements (z.B. Transistor) als stresssensitves Element ausreichen. Dieses ist jedoch auf Grund von parasitären Einflüssen nicht optimal.

Hauptvorteil der Verwendung von MOS Transistor-Feldplatten ist, dass deren Temperatur anhand der Schwellspannung, die im Wesentlichen unabhängig vom mechanischen Stress, aber abhängig von der Temperatur ist, ermittelt werden kann.

Somit ist eine exakte Trennung von mechanischem Stress und Temperatur möglich. Damit ist die Trennung der mechanischen von der thermischen Aktuatorwirkung möglich.

Für einige Anwendungen kann es sinnvoll sein, eine Biegespannung auf die Membran einzukoppeln. Da sich der Widerstand, der als Heizer verwendet wird, oberflächennah befindet, ist die Dehnung an der Oberfläche der Membran größer als an deren Unterkante. Dieser Effekt kann noch verstärkt werden, wenn der Widerstand mit einem Material mit einem gegenüber Silizium erhöhten thermischen Ausdehnungskoeffizienten bedeckt wird. Dies ist beispielsweise bei einem Metall, insbesondere einer AlSi-Metallisierung der Fall.

Fig. 2 zeigt die Aufsicht auf einen beispielhaften Sensor nach der Erfindung.

Der Sensor nach Fig. 2 weist die bereits oben erwähnte, als das eigentliche Sensorelement arbeitende FET-Feldplatte 17 auf, die über die vier Leitungen 18,19,20,21 mit vier Anschluss-Pads 24,25,26,27 verbunden ist. Der Aktuator ist als Heizelement ausgebildet und weist den Widerstand 29 und die metallische Abdeckung desselben 30 auf. Er ist über Leitungen 22,23 mit den jeweiligen Anschluss-Pads 27,28 verbunden. Das Heizelement und das Sensorelement sind auf der Membran 16 platziert. Der Sensor 17 und der Aktuator 28,39,30 sind ferner mit einer Auswerte- und Ansteuereinheit 41 verbunden, die "On-Chip" oder aber auch extern angeordnet sein kann.

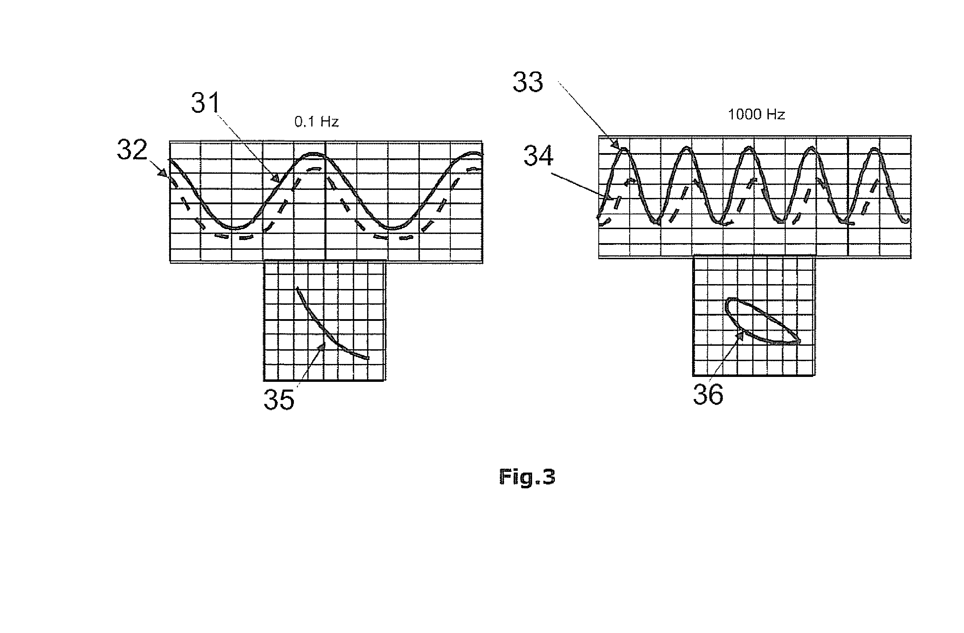

Fig. 3 zeigt das zeitliche Verhalten eines beispielhaften Sensors nach Fig. 2. Je schneller das Aktuator-Ansteuersignal oszilliert, desto größer wird die Phasenverschiebung zwischen Aktuatoransteuerung 31,33 und Sensorreaktion 32,34.

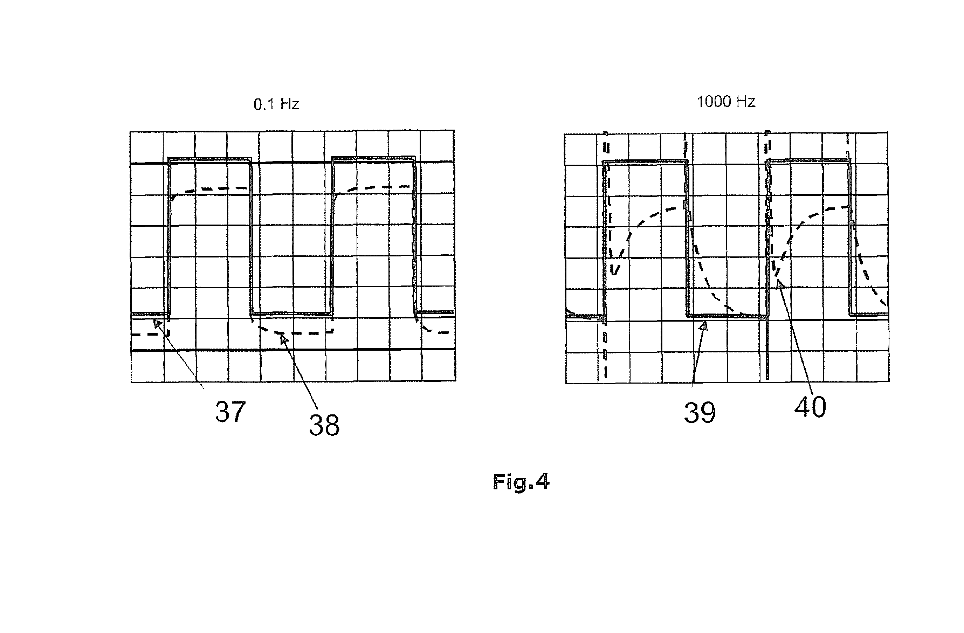

Wird das Heizelement nun mit einer Sprungfunktion angesteuert, so wölbt sich die Membran 2 (in diesem Beispielfall) nach oben (bei Anordnung des Heizelements an der Kavitäts-Innenseite nach unten) mechanisch durch, da das Metall einen höheren Ausdehnungskoeffizienten besitzt. Ist die Membran bereits in die andere Richtung - z.B. infolge des anliegenden Druckes - durchgebogen, so kommt es zu einem bistabilen Zustand. Die Membran verkürzt sich und entspannt sich schlagartig beim Sprung in den lokal anders gebogenen Zustand. Hierdurch tritt bei schneller Rechteckanregung 39 ein Spike-Verhalten 40 auf (siehe Fig. 4). Dieses lässt sich bei niedrigeren Frequenzen nicht unmittelbar beobachten (siehe bei 37 und 38 in Fig. 4).

Nach einiger Zeit hat sich die gesamte Membran erhitzt und ausgedehnt. Hierdurch wird der ursprüngliche Biegungszustand energetisch wieder stabiler und stellt sich ein.

Somit hängt das Frequenz- und Impulsverhalten des mechanischen Systems wesentlich von dessen Parametern und damit von deren Fertigungsabweichungen ab.

Ein wesentlicher Schritt besteht nun darin, nicht etwa zu versuchen, diese Parameter zu bestimmen, sondern lediglich das dynamische Verhalten eines gefertigten Sensorsystems daraufhin zu untersuchen, ob es dem Verhalten im Rahmen vorgegebener Toleranzen entspricht, das von einem Gut-System bekannt ist.

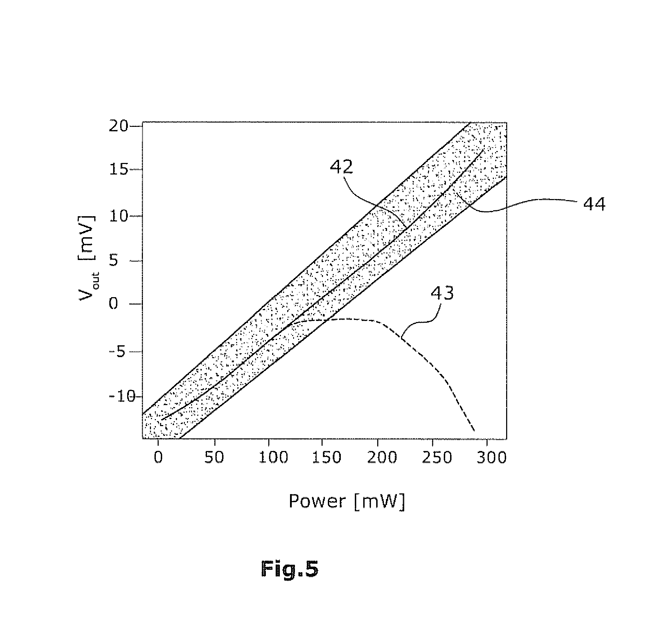

So kann beispielsweise das Ausgangssignal einer Messbrücke, entsprechend Fig. 2 in Abhängigkeit von dem Aktuatorzustand (hier Heizleistung) untersucht werden. Fig. 5 zeigt die Antwort je eines beispielhaften Sensors gemäß Fig. 2. Die Kurve 42 zeigt das Ausgangssignal eines vorschriftsmäßig gefertigten und arbeitenden Sensors in Abhängigkeit von der Heizleistung. Die Kurve 43 zeigt das gleiche Ausgangssignal für einen fehlerhaft gefertigten Sensor. Der hier beispielhafte fehlerhafte Sensor weist bei genauer Charakterisierung einen fehlerhaften Temperaturkoeffizienten des Ausganssignal-Offsets auf. Mit 44 ist der Toleranzbereich bezeichnet, innerhalb dessen das Ausgangssignal eines als akzeptabel zu qualifizierenden Sensors liegt.

Somit können durch eine solchermaßen dynamische Messung eine Reihe wichtiger Fertigungsfehler des elektromechanischen Gesamtsystems auf dem Wafer ermittelt werden, ohne aufwendig verschiedene Temperaturen und Drücke anfahren zu müssen. Diese können vielmehr zu einem abweichenden dynamisch-mechanischen Verhalten und einer geänderten Temperaturleitfähigkeit führen.

Diese erfindungsgemäß vorgesehenen Messungen können darüber hinaus auch nach dem Verbau eines solchermaßen gestalteten Sensors in ein komplexeres Gesamtsystem weiter für Selbsttestzwecke genutzt werden.

### BEZUGSZEICHENLISTE

- 1: Halbleitersubstrat (z.B. Silizium-Wafer)
- 1a: Oberseite des Halbleitersubstrats
- 2: Membran mit Zentral-Boss
- 2a: Kavität unterhalb der Membran
- 3: Piezo-Widerstand der Wheatstonebrücke in Nord-Position
- 4: Piezo-Widerstand der Wheatstonebrücke in Ost-Position
- 5: Piezo-Widerstand der Wheatstonebrücke in Süd-Position
- 6: Piezo-Widerstand der Wheatstonebrücke in West-Position
- 7: Heizer in Nord-West-Position
- 8: Heizer in Nord-Ost-Position
- 9: Heizer in Süd-Ost-Position
- 10: Heizer in Süd-West-Position
- 11: Rand der Kavität unter der Membran
- 12: Ausdünnung der Membran zur Steuerung des mechanischen Stressfeldes innerhalb der Membran (Race-Track).
- 13: Beispielhafte Anschlüsse
- 14: Außenkante des Race-Tracks. Diese sollte einen Mindestabstand von der Kavitätswand 14 einhalten.
- 15: Ultrakleiner Drucksensor in Aufsicht auf die Membran
- 16: Kavitätswand unter der Membran (verdeckt)
- 17: FET-Brücke zur Detektion des mechanischen Stresses
- 18: Verbindungsleitung zum Ausgangs-Pad 24
- 19: Verbindungsleitung zum GND-Anschluss 25
- 20: Verbindungsleitung zum zweiten Ausgangs-Pad 26
- 21: Verbindungsleitung zum VDD-Anschluss 27
- 22: Verbindung zwischen thermischen Aktuator 29 und VDD-Anschluss 27
- 23: Verbindung zwischen thermischem Aktuator 29 und Aktuator-Anschluss 28
- 24: Vsig- Signalausgang
- 25: GND Anschluss
- 26: Vsig+ Signalausgang
- 27: VDD Versorgungsspannungsanschluss
- 28: Aktuator (Heizer) Anschluss
- 29: Aktuator (Poly-Silizium-Heizer)
- 30: Aktuator-Verstärker (Metall-Platte)
- 31: Oszillogramm der Heizspannung des Sensors nach Fig. 2 (x-Achse ist die Zeit) bei 100mHz Sinusanregung
- 32: Oszillogramm der Brückenausgangsspannung des Sensors nach Fig. 2 (x-Achse ist die Zeit) bei 100mHz und Ansteuerung mit Signal 31
- 33: Oszillogramm der Heizspannung des Sensors nach Fig. 2 (x-Achse ist die Zeit) bei 1kHz Sinusanregung
- 34: Oszillogramm der Brückenausgangsspannung des Sensors nach Fig. 2 (x-Achse ist die Zeit) bei 1kHz und Ansteuerung mit Signal 34. Das Signal 34 ist gegenüber dem Signal 33 phasenverschoben.
- 35: Zu den Signalen 31 und 32 gehörendes x-y-Oszillogramm (keine Zeitablenkung)
- 36: Zu den Signalen 34 und 35 gehörendes x-y-Oszillogramm (keine Zeitablenkung)
- 37: Oszillogramm der Heizspannung des Sensors nach Fig. 2 (x-Achse ist die Zeit) bei 100mHz Rechteckanregung
- 38: Oszillogramm der Brückenausgangsspannung des Sensors nach Fig. 2 (x-Achse ist die Zeit) bei 100mHz und Ansteuerung mit Signal 37
- 39: Oszillogramm der Heizspannung des Sensors nach Fig. 2 (x-Achse ist die Zeit) bei 1kHz Rechteckanregung
- 40: Oszillogramm der Brückenausgangsspannung des Sensors nach Fig. 2 (x-Achse ist die Zeit) bei 1kHz und Ansteuerung mit Signal 39. Das Signal 40 ist gegenüber dem Signal 39 phasenverschoben. Außerdem tritt ein Spike auf.
- 41: Auswerte- und Ansteuereinheit
- 42: Kennlinie des Sensors nach Fig. 2: Ausgangsspannung in Abhängigkeit von der eingebrachten Heizleistung
- 43: Kennlinie des Sensors nach Fig. 2 mit Fertigungsfehlern: Ausgangsspannung in Abhängigkeit von der eingebrachten Heizleistung
- 44: Toleranzbereich

## Patentansprüche

1. Mikroelektromechanisches Bauelement mit
- einem Halbleitersubstrat (1),
- einer in dem Halbleitersubstrat (1) ausgebildeten Kavität (2a), die von einer reversibel verformbaren Membran (2) überdeckt ist,
- wobei die Membran (2) Bereiche aufweist, in denen sich bei einer Verformung der Membran (2) unterschiedlich große Materialspannungen einstellen,
- einem Sensor (17) zur Erfassung einer Verformung der Membran (2) und,
- einem Testaktuator (28,29,30) zur zu Testzwecken erfolgenden Verformung der Membran (2),
- wobei die Membran (2) an ihrem Rand, der mindestens zwei gegenüberliegende Randabschnitte aufweist, mit dem Halbleitersubstrat (1) verbunden ist und
- wobei die bei einer Verformung der Membran (2) in dieser hervorgerufenen Materialspannungen - über den gesamten Erstreckungsbereich der Membran (2) betrachtet - längs deren Rand am größten sind und
- wobei der Testaktuator (28,29,30) an derjenigen Stelle des einen Randabschnitts der Membran (2) angeordnet ist, an der sich bei einer Verformung der Membran (2) die maximale Materialspannung einstellt,
**dadurch gekennzeichnet,**
- **dass** der Sensor (17) an derjenigen Stelle des gegenüberliegenden anderen Randabschnitts der Membran (2), an der sich bei einer Verformung der Membran (2) die maximale Materialspannung einstellt, sowie dem Testaktuator (28,29,30) diametral gegenüberliegend angeordnet ist und
- **dass** damit der Abstand zwischen Testaktuator (28,29,30) und Sensor (17) - bezogen auf die Stellen der Randabschnitte der Membran (2) mit bei deren Verformung hervorgerufener maximaler Materialspannung - maximal ist.

2. Mikroelektromechanisches Bauelement nach Anspruch 1, **dadurch gekennzeichnet, dass** der Testaktuator (28,29,30) ein elektrothermischer Wandler zur lokalen Erwärmung der Membran (2) ist.

3. Mikroelektromechanisches Bauelement nach Anspruch 2, **dadurch gekennzeichnet, dass** der elektrothermische Wandler ein Heizelement (28,29,30) insbesondere ein Widerstandsheizelement zur Erwärmung einer auf der Membran (2) ausgebildeten Materialschicht (30), insbesondere Metallschicht oder eine unter anderem Metall aufweisende Schicht, des Heizelements (28,29,30) ist, wobei die Materialschicht (30) und das Halbleitersubstrat (1) unterschiedliche thermische Ausdehnungskoeffizienten aufweisen.

4. Mikroelektromechanisches Bauelement nach Anspruch 1, **dadurch gekennzeichnet, dass** der Testaktuator ein elektrostatisch-mechanischer oder ein magnetostatisch-mechanischer oder ein elektrodynamischer Wandler ist.

5. Mikroelektromechanisches Bauelement nach einem der Ansprüche 1 bis 4, **dadurch gekennzeichnet, dass** der Sensor (17) ein insbesondere piezoresistiver Transistor, insbesondere ein MOS- oder FET-Transistor ist.

6. Mikroelektromechanisches Bauelement nach einem der Ansprüche 1 bis 5, **gekennzeichnet durch** eine mit dem Sensor (17) und dem Testaktuator (28,29,30) verbundene Auswerte- und Ansteuereinheit (41) zur Ansteuerung des Testaktuators (28,29,30) zur testweisen Verformung der Membran (2) und zur Auswertung eines Messsignals des Sensors (17) als sensorische Erfassung einer Verformung der Membran (2) infolge der Ansteuerung des Testaktuators (28,29,30).

7. Verfahren zum Testen der Funktionalität eines mikroelektromechanischen Bauelements, das versehen ist mit
- einem Halbleitersubstrat (1),
- einer in dem Halbleitersubstrat (1) ausgebildeten Kavität (2a), die von einer reversibel verformbaren Membran (2) überdeckt ist,
- wobei die Membran (2) Bereiche aufweist, in denen sich bei einer Verformung der Membran (2) unterschiedlich große Materialspannungen einstellen,
- einem Sensor (17) zur Erfassung einer Verformung der Membran (2) und
- einem Testaktuator (28,29,30) zur zu Testzwecken erfolgenden Verformung der Membran (2),
- wobei die Membran (2) an ihrem Rand, der mindestens zwei gegenüberliegende Randabschnitte aufweist, mit dem Halbleitersubstrat (1) verbunden ist,
- wobei die bei einer Verformung der Membran (2) in dieser hervorgerufenen Materialspannungen - über den gesamten Erstreckungsbereich der Membran (2) betrachtet - längs deren Rand am größten sind,
- wobei der Testaktuator (28,29,30) an derjenigen Stelle des einen Randabschnitts der Membran (2) angeordnet ist, an der sich bei einer Verformung der Membran (2) die maximale Materialspannung einstellt,
- wobei der Sensor (17) an derjenigen Stelle des gegenüberliegenden anderen Randabschnitts der Membran (2), an der sich bei einer Verformung der Membran (2) die maximale Materialspannung einstellt, sowie dem Testaktuator (28,29,30) diametral gegenüberliegend angeordnet ist und
- wobei damit der Abstand zwischen Testaktuator (28,29,30) und Sensor (17) - bezogen auf die Stellen der Randabschnitte der Membran (2) mit bei deren Verformung hervorgerufener maximaler Materialspannung - maximal ist,
wobei bei dem Verfahren
- der Testaktuator (28,29,30) zur zu Testzwecken erfolgenden Verformung der Membran (2) angesteuert wird und anschließend anhand des Messsignals des Sensors (17) ermittelt wird, ob eine Verformung der Membran (2) erfasst wird.

8. Verfahren nach Anspruch 7, **dadurch gekennzeichnet, dass** anhand des Messsignals des Sensors (17) der Grad einer Verformung der Membran (2) ermittelt wird und dass der Grad der Verformung mit einer vorgebbaren Sollverformung verglichen wird.

## Claims

1. A microelectromechanical component comprising
- a semiconductor substrate (1),
- a cavity (2a) formed in the semiconductor substrate (1), which cavity is covered by a reversibly deformable membrane (2),
- wherein the membrane (2) has portions in which material tensions of different strengths occur during deformation of the membrane (2),
- a sensor (17) for detecting a deformation of the membrane (2), and
- a test actuator (28, 29, 30) for deforming the membrane (2) for test purposes,
- wherein the membrane (2), on its edge which comprises at least two opposite edge portions, is connected to the semiconductor substrate (1), and
- wherein - when viewed across the whole extension of the membrane (2) - the material tensions generated in the membrane (2) during deformation of the membrane (2) are maximal along the edge of the membrane, and
- wherein the test actuator (28,29,30) is arranged at that site of one edge portion of the membrane (2) in which the material tension is maximal during deformation of the membrane (2),
**characterized in**
- **that** the sensor (17) is arranged at that site of the opposite other edge portion of the membrane (2) in which the material tension is maximal during deformation of the membrane (2), and is arranged diametrically opposite to the test actuator (28,29,30), and
- **that**, thus - with regard to the sites of the edge portions of the membrane (2) in which the material tension is maximal during their deformation - the distance between the test actuator (28,29,30) and the sensor (17) is maximal.

2. The microelectromechanical component according to claim 1, **characterized in that** the test actuator (28,29,30) is an electrothermal transducer for the local heating of the membrane (2).

3. The microelectromechanical component according to claim 2, **characterized in that** the electrothermal transducer is a heating element (28,29,30), in particular a resistance heating element for heating a material layer (30) formed on the membrane (2), in particular a metal layer or a layer also including metal, of the heating element (28,29, 30), wherein the material layer (30) and the semiconductor substrate (1) have different thermal expansion coefficients.

4. The microelectromechanical component of claim 1, **characterized in that** the test actuator is an electrostatic-mechanical or a magnetostatic-mechanical or an electrodynamic transducer.

5. The microelectromechanical component of one of claims 1 to 4, **characterized in that** the sensor (17) is in particular a piezo-resistive transistor, especially a MOS or a FET transistor.

6. The microelectromechanical component of one of claims 1 to 5, **characterized by** an evaluation and activation unit (41), connected with the sensor (17) and the test actuator (28,29,30), for activating the test actuator (28,29,30) to deform the membrane (2) as a test and for evaluating a measuring signal of the sensor (17) as a sensor detection of a deformation of the membrane (2) as a result of the activation of the test actuator (28,29,30).

7. A method for testing the functionality of a microelectromechanical component that is provided with
- a semiconductor substrate (1),
- a cavity (2a) formed in the semiconductor substrate (1), which cavity is covered by a reversibly deformable membrane (2),
- wherein the membrane (2) comprises portions in which material tensions of different strength occur during deformation of the membrane (2),
- a sensor (17) for detecting a deformation of the membrane (2), and
- a test actuator (28,29,30) for deforming the membrane (2) for test purposes,
- wherein the membrane (2), on its edge which comprises at least two opposite edge portions, is connected to the semiconductor substrate (1),
- wherein - when viewed across the whole extension of the membrane (2) - the material tensions generated in the membrane (2) during deformation of the membrane (2) are maximal along the edge of the membrane,
- wherein the test actuator (28,29,30) is arranged at that site of one edge portion of the membrane (2) in which the material tension is maximal during deformation of the membrane (2),
- wherein the sensor (17) is arranged at that site of the opposite other edge portion of the membrane (2) in which the material tension is maximal during deformation of the membrane (2), and is arranged diametrically opposite to the test actuator (28,29,30), and
- wherein, thus - with regard to the sites of the edge portions of the membrane (2) in which the material tension is maximal during their deformation - the distance between the test actuator (28,29,30) and the sensor (17) is maximal,
wherein, in said method,
- the test actuator (28,29,30) is activated for deforming the membrane (2) for test purposes and, thereafter, it is determined from the measuring signal of the sensor (17) whether a deformation of the membrane (2) has been detected.

8. The method according to claim 7, **characterized in that** the degree of a deformation of the membrane (2) is determined from the measuring signal of the sensor (17) and that the degree of deformation is compared to a predeterminable target deformation.

## Revendications

1. Composant microélectromécanique, comprenant :
- un substrat semi-conducteur (1),
- une cavité (2a) formée dans le substrat semi-conducteur (1), qui est recouverte d'une membrane (2) déformable de manière réversible,
- la membrane (2) présentant des régions dans lesquelles sont générées des tensions de différentes valeurs dans le matériau lors d'une déformation de la membrane (2),
- un capteur (17) permettant de détecter une déformation de la membrane (2), et
- un actionneur de test (28, 29, 30) destiné à déformer la membrane (2) à des fins de test,
- la membrane (2) étant reliée au substrat semi-conducteur (1) au niveau de son bord présentant au moins deux segments de bord opposés, et
- les tensions de matériau provoquées dans la membrane (2) lors d'une déformation de celle-ci - considérées sur toute l'étendue de la membrane (2) - étant à leur maximum le long de son bord, et
- l'actionneur de test (28, 29, 30) étant disposé à l'endroit de l'un des segments de bord de la membrane (2) où est générée la tension maximale dans le matériau lors d'une déformation de la membrane (2),
**caractérisé**
- **en ce que** le capteur (17) est disposé à l'endroit de l'autre segment de bord opposé de la membrane (2) où est générée la tension maximale dans le matériau lors d'une déformation de la membrane (2) et de manière diamétralement opposée à l'actionneur de test (28, 29, 30), et
- **en ce que** la distance entre l'actionneur de test (28, 29, 30) et le capteur (17) - rapportée aux endroits des segments de bord de la membrane (2) qui présentent la tension maximale dans le matériau provoquée lors de sa déformation - est maximale.

2. Composant microélectromécanique selon la revendication 1, **caractérisé en ce que** l'actionneur de test (28, 29, 30) est un convertisseur électrothermique pour l'échauffement local de la membrane (2).

3. Composant microélectromécanique selon la revendication 2, **caractérisé en ce que** le convertisseur électrothermique est un élément chauffant (28, 29, 30), en particulier un élément chauffant par résistance destiné à échauffer une couche de matériau (30) formée sur la membrane (2), en particulier une couche métallique ou une couche comportant, entres autres, du métal, de l'élément chauffant (28, 29, 30), la couche de matériau (30) et le substrat semi-conducteur (1) présentant différents coefficients de dilatation thermique.

4. Composant microélectromécanique selon la revendication 1, **caractérisé en ce que** l'actionneur de test est un convertisseur électrostatique et mécanique ou magnétostatique et mécanique ou électrodynamique.

5. Composant microélectromécanique selon l'une des revendications 1 à 4, **caractérisé en ce que** le capteur (17) est un transistor en particulier piézorésistif, notamment un transistor MOS ou FET.

6. Composant microélectromécanique selon l'une des revendications 1 à 5, **caractérisé par** une unité d'évaluation et de commande (41) reliée au capteur (17) et à l'actionneur de test (28, 29, 30) et permettant de commander l'actionneur de test (28, 29, 30) pour déformer la membrane (2) à des fins de test et pour évaluer un signal de mesure émis par le capteur (17) en tant que détection par le capteur d'une déformation de la membrane (2) suite à la commande de l'actionneur de test (28, 29, 30).

7. Procédé permettant de tester la fonctionnalité d'un composant microélectromécanique pourvu :
- d'un substrat semi-conducteur (1),
- d'une cavité (2a) formée dans le substrat semi-conducteur (1), qui est recouverte d'une membrane (2) déformable de manière réversible,
- la membrane (2) présentant des régions dans lesquelles sont générées des tensions de différentes valeurs dans le matériau lors d'une déformation de la membrane (2),
- d'un capteur (17) permettant de détecter une déformation de la membrane (2), et
- d'un actionneur de test (28, 29, 30) destiné à déformer la membrane (2) à des fins de test,
- la membrane (2) étant reliée au substrat semi-conducteur (1) au niveau de son bord présentant au moins deux segments de bord opposés,
- les tensions de matériau provoquées dans la membrane (2) lors d'une déformation de celle-ci - considérées sur toute l'étendue de la membrane (2) - étant à leur maximum le long de son bord,
- l'actionneur de test (28, 29, 30) étant disposé à l'endroit de l'un des segments de bord de la membrane (2) où est générée la tension maximale dans le matériau lors d'une déformation de la membrane (2),
- le capteur (17) étant disposé à l'endroit de l'autre segment de bord opposé de la membrane (2) où est générée la tension maximale dans le matériau lors d'une déformation de la membrane (2), et de manière diamétralement opposée à l'actionneur de test (28, 29, 30), et
- la distance entre l'actionneur de test (28, 29, 30) et le capteur (17) - rapportée aux endroits des segments de bord de la membrane (2) qui présentent la tension maximale dans le matériau provoquée lors de sa déformation - étant maximale,
procédé dans lequel
- l'actionneur de test (28, 29, 30) est commandé pour déformer la membrane à des fins de test, après quoi on détermine à l'aide du signal de mesure du capteur (17) si une déformation de la membrane (2) est détectée.

8. Procédé selon la revendication 7, **caractérisé en ce que** le degré de déformation de la membrane (2) est déterminé à l' aide du signal de mesure du capteur (17) et **en ce que** le degré de déformation est comparé à une déformation théorique pouvant être prédéfinie.
